(19) Europäisches Patentamt
European Patent Office
Office européen des brevets

(11) **EP 4 451 505 A1**

(12) **EUROPEAN PATENT APPLICATION**

(43) Date of publication:
**23.10.2024 Bulletin 2024/43**

(21) Application number: **24150263.2**

(22) Date of filing: **03.01.2024**

(51) International Patent Classification (IPC):
**H02J 7/00** *(2006.01)*

(52) Cooperative Patent Classification (CPC):
**H02J 7/00714; H02J 7/005; H02J 7/007182; H02J 7/007194**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.04.2023 KR 20230050965**

(71) Applicant: **Samsung SDI Co., Ltd.**
**Yongin-si, Gyeonggi-do 17084 (KR)**

(72) Inventor: **KIM, Hwa-Su**
**17084 Yongin-si (KR)**

(74) Representative: **Marks & Clerk LLP**
**15 Fetter Lane**
**London EC4A 1BW (GB)**

(54) **CHARGING CONTROL METHOD, AND CHARGING CONTROL DEVICE AND BATTERY PACK PERFORMING THE SAME**

(57) One or more embodiments provide a charging control device including a storage device configured to store tables defining a correlation between a change in capacity and a change in voltage of a cell, and map and store lifespan states and temperatures corresponding to the tables, and a control device configured to obtain a table corresponding to a current state of a battery module from the tables based on a lifespan state and a temperature of the battery module at a charging start time point, obtain a predicted voltage value for the battery module using the table and an accumulated current amount obtained by accumulating charging currents detected while charging is in progress, and control a charging current according to a comparison result of comparing a measured voltage value that is measured in the battery module with the predicted voltage value.

FIG. 2

**Description**

**BACKGROUND OF THE INVENTION**

**1. Field**

The present disclosure relates to a charging control method, and a charging control device and a battery pack performing the same.

**2. Description of Related Art**

A rechargeable or secondary battery differs from a primary battery, which provides only irreversible conversion of chemical materials into electrical energy, in that a rechargeable or secondary battery can be charged and discharged repeatedly. Low-capacity rechargeable batteries are used as power supplies for small electronic devices, such as mobile phones, notebook computers, and camcorders, while high-capacity rechargeable batteries are used as power supplies, such as an energy storage system (ESS) or uninterruptible power supply (UPS) system using medium and large batteries used for electric vehicles (EVs), hybrid vehicles (HVs), or home or industry.

In general, the secondary battery includes an electrode assembly including a positive electrode, a negative electrode, and a separator interposed between the positive and negative electrodes, a case accommodating the electrode assembly, and an electrode terminal electrically connected to the electrode assembly. An electrolyte solution is injected into the case to enable charging and discharging of the battery through an electrochemical reaction between the positive electrode, the negative electrode, and the electrolyte solution. A shape of the case, such as a cylindrical or rectangular shape, may depend on the purpose of the battery.

The rechargeable battery may be used as a battery module formed of a plurality of unit cells connected in series and/or parallel to provide high energy density, for example, for driving a motor of a hybrid vehicle. That is, the battery module is formed by interconnecting electrode terminals of a plurality of unit cells according to an amount of power suitable to implement, for example, a high-power rechargeable battery for an electric vehicle. One or more battery modules are mechanically and electrically integrated to configure a battery pack.

To meet dynamic power demands of various electrical consumer devices connected to the battery pack, static control of battery power output and charging may not be sufficient. Accordingly, information may be constantly or intermittently exchanged between the battery pack and the controllers of the electrical consumer devices. This information may include battery pack actual state of charge (SOC), potential electrical performance, charging capability, and internal resistance as well as actual or projected power demand or consumer surplus.

For monitoring, control, and/or setting of the aforementioned parameters, the battery pack may include control electronics. These control electronics may be essential components of the battery pack, may be located in a common housing, or may be a part of a remote control unit that communicates with the battery pack through an appropriate communication bus. These control electronics may perform various functions in the battery pack.

The control electronics of the battery pack, for example, a battery system manager (BSM), a battery management system (BMS), a battery monitoring unit (BMU), or a system basis chip (SBC) may be powered by the battery pack controlled by them. In this way, an additional power source for the control electronics may be omitted, thereby reducing the installation space requirement of the battery pack. However, depending on the output voltage of the battery pack, for example, a high voltage battery pack, such as 48 V, may suitably use adjustment of the output voltage to supply power to the control electronics.

Recently, as the supply of electric vehicles or hybrid vehicles equipped with battery packs increases, there is an increasing desire for ways to increase the lifespan of the battery pack while increasing the charging speed of the battery pack. Because the charging speed and lifespan of the battery pack conflict with each other, as the charging speed of the battery pack is increased, deterioration of the battery pack may be accelerated, and the lifespan of the battery pack may be reduced.

Therefore, it may be suitable to study a method of increasing the charging speed of the battery pack while suppressing deterioration of the battery pack as much as possible.

**SUMMARY**

Embodiments provide a charging control method, and a charging control device and battery pack for performing the same, that may increase a charging speed of a battery pack while suppressing deterioration of the battery pack as much as possible.

One or more embodiments provide a charging control device including a storage device configured to store tables defining a correlation between a change in capacity and a change in voltage of a cell and corresponding to different lifespan states and temperatures of the cell, and a control device configured to obtain a table corresponding to a current state of a battery module from the tables based on a lifespan state and a temperature of the battery module at a charging start time point, obtain a predicted voltage value for the battery module using the obtained table and an accumulated current amount obtained by accumulating charging currents detected while charging is in progress, and control a charging current according to a comparison result of comparing a measured voltage value that is measured in the battery module with the predicted voltage value.

The capacity of a cell may refer to the quantity of electric charge accumulated in the cell. The accumulated current amount may refer to an increase in capacity of the cell as a result of the charging currents.

The voltage of the cell may refer to the potential difference between the terminals of that cell.

The lifespan states are lifespan states of the cell for which the correlations defined in the tables are provided. Each of the lifespan states may be a different state of health (SOH) value - e.g. 100 %, 90%, 80% - of the cell.

The temperatures are temperatures of the cell for which the correlations defined in the tables are provided.

Each of the tables may be associated with a unique combination of lifespan state and temperature for the cell.

Each of the tables may define multiple correlations between the change in capacity and change in voltage for different values of the state of charge. Each of the correlations in the tables may be an indication of a differential value (dV/dQ) of the voltage with respect to the capacity of the cell. Obtaining the predicted voltage value may comprise integrating the differential value with respect to the capacity of the cell between a charging start point and a point at which the measured voltage value is measured.

Obtaining the predicted voltage value may comprise summing changes in the voltage value for the battery module, where each of the summed changes in voltage is determined from the obtained table and associated with a change in the capacity.

The tables may include a differential value (dV/dQ) of a voltage with respect to a capacity of the cell, or may include a value derived from the differential value (dV/dQ).

The control device may be configured to calculate a voltage change amount from the charging start time point to a current time point corresponding to the accumulated current amount using the obtained table, and obtain the predicted voltage value by adding the voltage change amount to a charging start voltage value of the battery module detected at the charging start time point.

The control device may be configured to determine a state of charge (SOC) of the battery module at the current time point based on the accumulated current amount, extract differential values (dV/dQ) from the obtained table based on a charging start state of charge (SOC) at the charging start time point of the battery module and the state of charge (SOC) at the current time point, and calculate the voltage change amount using the differential values (dV/dQ) extracted from the obtained table.

The control device may be configured to decrease the charging current if a difference between the predicted voltage value and the measured voltage value exceeds a threshold value.

The control device is configured to increase the charging current if the difference between the predicted voltage value and the measured voltage value is less than the threshold value.

The threshold value may include a single value, or may include a range having an upper limit value and a lower limit value. In the case in which the threshold value includes an upper limit value and a lower limit value, the control device may be configured to increase the charging current if the difference between the predicted voltage value and the measured voltage value is less than the lower limit value and to decrease the charging current if the difference between the predicted voltage value and the measured voltage value is greater than the upper limit value.

The control device may be configured to exclude a current component due to direct current internal resistance (DCIR) from the accumulated current amount.

The control device may be configured to communicate with a charging device, and to control the charging current applied from the charging device to the battery module through communication.

One or more other embodiments provide a battery pack including the battery module including cells, and the charging control device.

The control device may be configured to obtain the table corresponding to the current state of the battery module based on a lifespan state and a temperature detected at the charging start time point for a representative cell selected from among the cells.

The representative cell may have a largest deterioration state among the cells.

The control device may be configured to obtain the table corresponding to the current state of the battery module based on average values of lifespan states and temperatures detected at the charging start time point for the cells.

One or more other embodiments provide a charging control method of a battery pack, the method including selecting, based on a lifespan state and a temperature at a charging start time point of a battery module, a table corresponding to a current state of the battery module from among tables that define a correlation between a change in capacity and a change in voltage of a cell, and that correspond to different lifespan states and temperatures of the cell, obtaining an accumulated current amount by accumulating a charging current detected during charging, obtaining a predicted voltage value for the battery module using the selected table and the accumulated current amount, and controlling the charging current based on a measured voltage value that is measured in the battery module and the predicted voltage value.

The table may include a differential value (dV/dQ) of a voltage with respect to a capacity of the cell, or includes a value derived from the differential value (dV/dQ).

Obtaining the predicted voltage value may include calculating a voltage change amount from the charging start time point to a current time point using the selected table and the accumulated current amount, and adding the voltage change amount to a charging start voltage value of the battery module detected at the charging start time point.

Calculating the voltage change amount may include determining a state of charge (SOC) of the battery module at the current time point based on the accumulated current amount, extracting the differential value (dV/dQ) from the selected table based on a charging start state of charge (SOC) at the charging start time point of the battery module and the state of charge (SOC) at the current time point, and calculating the voltage change amount using the differential value (dV/dQ) extracted from the selected table corresponding to the current state of the battery module.

Controlling the charging current may include decreasing the charging current if a difference between the predicted voltage value and the measured voltage value exceeds a threshold value.

Controlling the charging current may include increasing the charging current if the difference between the predicted voltage value and the measured voltage value is less than the threshold value.

The threshold value may include a single value, or includes a range having an upper limit value and a lower limit value.

Obtaining the accumulated current amount may include accumulating the charging current and excluding a current component due to direct current internal resistance (DCIR) from the accumulated current amount.

According to the embodiments, there is an effect of increasing a charging speed while suppressing deterioration of a battery pack.

One or more other embodiments provide a charging control method of a battery pack, the method including selecting, based on a lifespan state and a temperature at a charging start time point of a battery module, a table corresponding to a current state of the battery module from among tables that define a correlation between a change in capacity and a change in voltage of a cell, and that correspond to different lifespan states and temperatures of the cell, obtaining an accumulated current amount by accumulating a charging current detected during charging, obtaining a predicted voltage value for the battery module using the selected table and an accumulated current amount, and controlling the charging current based on a measured voltage value that is measured in the battery module and the predicted voltage value.

At least some of the above and other features of the invention are set out in the claims.

## BRIEF DESCRIPTION OF THE DRAWINGS

FIG. 1 illustrates a schematic block diagram of a battery pack according to one or more embodiments.

FIG. 2 illustrates an example of a dV/dQ table used in a charging control device according to one or more embodiments.

FIG. 3 is a drawing for explaining a method of predicting a current voltage value of a cell by using a dV/dQ table in a charging control device according to one or more embodiments.

FIG. 4 schematically illustrates a charging control method of a charging control device according to one or more embodiments.

## DETAILED DESCRIPTION

Embodiments of the present disclosure will now be described in detail with accompanying drawings. Hereinafter, an operation effect and a method of implementing the same according to embodiments of the present disclosure will be described with reference to the accompanying drawings. In the drawings, the same reference numerals denote the same elements, and redundant explanations will be omitted. However, the present disclosure may be embodied in various forms, and should not be construed as being limited only to the embodiments shown herein. Rather, these embodiments are provided by way of example to make the present disclosure thorough and complete, and will fully convey aspects and features of the present disclosure to those skilled in the art.

Hence, for the purpose of complete understanding on the aspects and the characteristics of the present disclosure, processes, factors, and skills that may not be needed by a person of ordinary skill in the art may not be described. In the drawings, relative sizes of elements, layers, and regions may be exaggerated for clarity.

As used herein, the term "and/or" includes any and all combinations of one or more related listed items. The use of "can/may" in describing one or more embodiments of the present disclosure indicates "one or more embodiments of the present disclosure."

In the following description of embodiments of the present invention, terms in the singular form may include plural forms unless the context clearly indicates otherwise.

It will be understood that the terms "first" and "second" are used to describe various elements, but these elements should not be limited by these terms. These terms are only used to distinguish one element from another. For example, a first constituent element may be referred to as a second constituent element, and the second constituent element may also be referred to as the first constituent element without departing from the scope of the present disclosure. As used herein, the term "and/or" includes any and all combinations of one or more related listed items. An expression, such as "at least one" precedes a list of elements, modifying the entire list of elements and not individual elements of the list.

As used in this specification, the terms "substantially", "approximately", and similar terms are used as approximate terms but are not used as degree terms, and they are not intended to illustrate inherent deviations of measured or calculated values evident to those skilled in the art. In addition, if the term "substantially" is used in combination with a characteristic that can be expressed using numerical values, the term "substantially" refers to including a range of +/- 5 % of the value.

It will be understood that if a constituent element or layer is referred to as being "on," "connected to," or "coupled to" another constituent element or layer, it can be directly on, connected to, or coupled to the other constituent element or layer, or one or more intervening constituent elements or layers may be present. In addition, it will also be understood that if a constituent element or layer is referred to as being "between" two constituent elements or layers, it can be the only constituent element or layer between the two constituent elements or layers, or one or more intervening constituent elements or layers may also be present.

Electrically connecting two constituent elements includes directly connecting two constituent elements and connecting the same with another constituent element therebetween. The other constituent element may include a switch, a resistor, and a capacitor. When the embodiments are described, an expression of connection signifies electrical connection if an expression of direct connection is not provided.

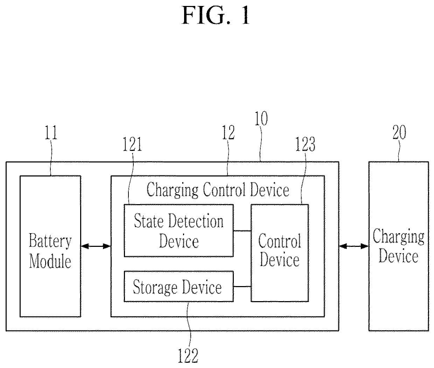

FIG. 1 illustrates a schematic block diagram of a battery pack according to one or more embodiments.

Referring to FIG. 1, a battery pack 10 according to one or more embodiments may include a battery module 11 and a charging control device 12.

The battery module 11 may include at least one cell. If the battery module 11 includes a plurality of cells, the plurality of cells may be connected in series and/or in parallel.

The charging control device 12 is a device for controlling charging of the battery module 11, and may include a state detection device 121, a storage device 122, and a control device 123.

The state detection device 121 may continuously measure and detect values related to cell states, such as voltages, charging and discharging currents, and temperatures of cells that configure the battery module 11. The state detection device 121 may transmit the detected state values to the control device 123.

The storage device 122 may store information processed by the charging control device 12. The storage device 122 may store a table (hereinafter referred to as a "dV/dQ table") defining a correlation between a change in capacity and a change in voltage of a cell (for example, a differential value (dV/dQ) of a voltage with respect to a cell's capacity (or a ratio of a change in voltage with respect to a change in capacity of a cell), or a value derived therefrom). The dV/dQ curve of the cell may vary depending on the state of health (SOH) (or deterioration state) and the temperature of the cell. In one or more embodiments, the storage device 122 may map and store the dV/dQ table corresponding to each cell's SOH and temperature.

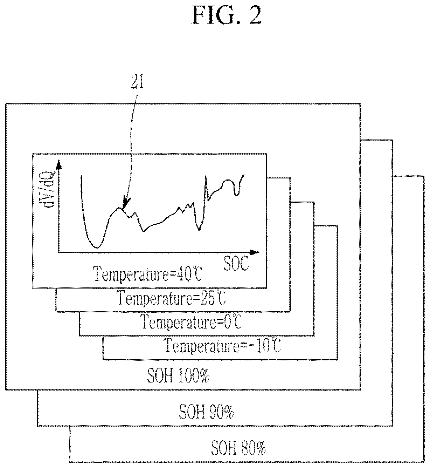

FIG. 2 illustrates an example of the dV/dQ table used in the charging control device according to one or more embodiments.

Referring to FIG. 2 as an example, the charging control device 12 may convert and store a dV/dQ curve 21 that varies according to the SOH (for example, SOH 100 %, SOH 90 %, SOH 80 %) and the temperature (for example, -10 °C, 0 °C, 25 °C, 40 °C) of the cell in a table form. Even if the cells have the same SOH, different temperatures may result in different dV/dQ curves 21. For example, the dV/dQ curve 21 for a cell with 100 % SOH may develop differently if the temperature is -10 °C as compared to if the temperature is 40 °C. In one or more embodiments, the charging control device 12 may map and store a dV/dQ table corresponding to each combination of SOH and temperature of the cell. Referring to FIG. 2, the dV/dQ curve 21 may indicate a change in the dV/dQ value according to a change in the SOC of a cell. In one or more embodiments, each dV/dQ table may be generated in a form in which the dV/dQ values corresponding to each SOC are mapped. In one or more embodiments, the dV/dQ curve 21 may be obtained through simulation performed while changing the SOH and the temperature for cells having the same specifications as those configuring the battery module 11.

Referring back to FIG. 1, the control device 123 may monitor the state of the battery module 11, and may control a charging operation of the battery module 11.

The control device 123 may determine the state (voltage, current, temperature, SOC, SOH, and the like) of each cell configuring the battery module 11 based on the state values obtained from the state detection device 121. Because the technology for determining the SOC and SOH of a cell is, generally, a well-known technology in the field of battery technology, a detailed description thereof is omitted in the present disclosure.

If the battery pack 10 is connected to the charging device 20 and a charging start signal is inputted, the control device 123 may obtain the SOH and the temperature at the time the charging start signal is inputted to the battery module 11 (hereinafter referred to as a "charge start time point") based on state values obtained from the state detection device 121.

If the battery module 11 includes a plurality of cells, the SOH and the temperature obtained for the battery module 11 may be the SOH and the temperature of one cell selected from the battery module 11. The control device 123 may select a representative cell from among the cells configuring the battery module 11, and may obtain the SOH and the temperature of the selected representative cell at a charging start time point as the SOH and the temperature of the battery module 11. For example, the control device 123 may select a weak cell having the greatest deterioration state as a representative cell.

If the battery module 11 includes a plurality of cells, the SOH and the temperature obtained for the battery module 11 may be an average SOH and an average temperature of the cells configuring the battery module 11. The control device 123 may obtain the SOH and the temperature at the charging start time point for the plurality of cells configuring the battery module 11, and may obtain an average of these values as the SOH and the temperature of the battery module 11.

The control device 123 may obtain the dV/dQ table corresponding to the current state of the battery module 11 from the dV/dQ table stored in the storage device 122 based on the SOH and the temperature obtained for the battery module 11 at the charging start time point.

If the dV/dQ table corresponding to the SOH and the temperature of the battery module 11 is stored in the storage device 122, the control device 123 may read the dV/dQ table from the storage device 122, and may use the dV/dQ table as the dV/dQ table corresponding to the current state of the battery module 11. If the dV/dQ table corresponding to the SOH and the temperature of the battery module 11 is not stored in the storage device 122, the control device 123 may use the dV/dQ tables stored in the storage device 122 to determine the dV/dQ table corresponding to the current state of the battery module 11 in various ways. For example, among dV/dQ tables stored in the storage device 122, the control device 123 may read a dV/dQ table mapped to the SOH and the temperature of the battery module 11 close to the current SOH and the current temperature of the battery module 11 to use the dV/dQ table as the dV/dQ table corresponding to the current state of the battery module 11. In one or more embodiments, for example, the control device 123 may generate the dV/dQ table corresponding to the current state of the battery module 11 from the dV/dQ table stored in the storage device 122 by using an interpolation method or the like.

If the dV/dQ table corresponding to the current state of the battery module 11 is obtained, the control device 123 may determine a starting point in the corresponding dV/dQ table. The starting point may be determined by the SOC of the battery module 11 obtained at the charging start time point (hereinafter referred to as a "charging start SOC"). At the charging start time point, the control device 123 may determine the voltage of the battery module 11 (hereinafter, referred to as a "charging start voltage") and the capacity of the battery module 11 (hereinafter referred to as a "charging start capacity") based on the state values detected by the state detection device 121. If the battery module 11 includes a plurality of cells, the control device 123 may determine the charging start SOC, charging start voltage, and charging start capacity of the battery module 11 based on the state value of the representative cell selected from among the cells configuring the battery module 11, or based on the average state value of the cells configuring the battery module 11. For example, the control device 123 may determine the SOC, voltage, and capacity detected at the charging start time point for the representative cell selected from the battery module 11 as the charging start SOC, charging start voltage, and charging start capacity of the battery module 11. In addition, and for example, the control device 123 may determine the average values of SOC, voltage, and capacity detected at the charging start time point from the cells configuring the battery module 11 as the charging start SOC, charging start voltage, and charging start capacity of the battery module 11.

The control device 123 may store the charging start SOC, charging start voltage, and charging start capacity obtained from the battery module 11 at the charging start time point in the storage device 122.

The control device 123 may accumulate the current amount value of the charging current while the battery module 11 is being charged, and may use the accumulated amount of current and a dV/dQ table corresponding to the current state of the battery module 11 to predict the current voltage value of the battery module 11 (e.g., the current voltage value of the cells configuring the battery module 11). The control device 123 may estimate the current SOC of the battery module 11 (e.g., the current SOC of the cells configuring the battery module 11) based on the accumulated amount of current. In one or more embodiments, the control device 123 may reduce or prevent the effect of the direct current internal resistance (DCIR) on the result by excluding a current component due to the DCIR from the accumulated amount of current if the charging current is accumulated. If the current SOC of the battery module 11 is determined, the control device 123 may predict the current voltage value of the battery module 11 by using the dV/dQ table corresponding to the current state of the battery module 11.

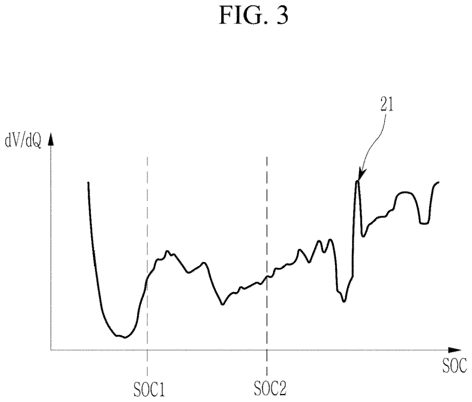

FIG. 3 is a drawing for explaining a method of predicting a current voltage value of a cell by using a dV/dQ table in a charging control device according to one or more embodiments.

In FIG. 3, SOC1 and SOC2 respectively indicate the charging start SOC and current SOC of the cell. The control device 123 may extract dV/dQ values in the SOC1 to SOC2 section from the dV/dQ table, and may use the extracted dV/dQ values to calculate the voltage change of the cell from the charging start time point to the current time point. In one or more embodiments, the control device 123 may estimate the current voltage of the cell by adding the calculated voltage change to the charging start voltage.

Equation 1 below shows a method that calculates the voltage change of a cell from the charging start time point to the current time point, and that uses this to predict the current voltage of the cell.

## Equation 1

$$V_e = V_s + \sum_{Q_s}^{Q_e} dV$$

In Equation 1, Vs and Ve may represent a charging start voltage and a predicted current voltage of a cell, respectively, Qs and Qe may represent a charging start capacity and a current capacity of the cell, respectively, and dV may represent a voltage change amount. In one or more embodiments, the control device 123 may calculate the total voltage change amount by accumulating the voltage change (dV) according to the capacity change (dQ) of the cell, and may predict the current voltage (Ve) of the cell by adding the voltage change (dV) to the charging start voltage (Vs). Here, Qs and Qe are capacity values corresponding to the charging start SOC and the current SOC of the cell, and may be calculated using the total capacity of the cell, the charging start SOC, and the current SOC. In one or more embodiments, the voltage change (dV) according to the capacity change (dQ) is derived using the dV/dQ values extracted from the dV/dQ table, and the accumulated dV value may vary according to the capacity value of the cell.

If converting a dV/dQ curve into the form of a dV/dQ table, as the resolution is increased, the accuracy of voltage prediction using the dV/dQ table may be increased. However, the resolution of the dV/dQ table may be limited due to limitations in the usage environment, such as storage space and system performance. Therefore, the control device 123 may calculate and use a corresponding dV/dQ value from adjacent dV/dQ values using an interpolation method for SOC values for which the dV/dQ value is not defined by the dV/dQ table.

Referring back to FIG. 1, the control device 123 may continuously predict the voltage value of the cell configuring the battery module 11 using the dV/dQ table as described above.

If a voltage value of the cell configuring the battery module 11 is predicted, the control device 123 may compare the predicted voltage value with a current voltage value actually measured using the state detection device 121. During normal charging of the cell (for example, during low-rate charging), lithium (Li) ions from a positive electrode move at a stable rate to intercalate on a surface of a negative electrode, so that it is possible to predict the voltage of the cell using the dV/dQ table. However, if the movement speed of the lithium (Li) ions is relatively faster than the intercalation speed on the surface of the negative electrode because the charging current is large or because the temperature is low, a precipitation phenomenon may occur on the surface of the negative electrode. In one or more embodiments, due to the precipitation phenomenon, the negative electrode potential of the cell is different from that during normal charging, and the voltage of the cell is different from the predicted value using the dV/dQ table. Therefore, it is possible to check whether the battery module 11 is charging in an area in which the cell deterioration is severe by comparing the voltage value predicted using the dV/dQ table with the actually measured voltage value.

If the difference between the predicted voltage value and the measured voltage value exceeds a threshold value, (e.g., if the voltage difference obtained by subtracting the measured voltage value from the predicted voltage value becomes greater than the threshold value), then the control device 123 may determine that the battery module 11 is being charged in the charging deterioration area of the cell. In one or more embodiments, if it is determined that the battery module 11 is being charged in the charging deterioration area, the control device 123 may request the charging device 20 to decrease the charging current through communication. The control device 123 may request the charging device 20 to increase the charging current again if the voltage difference obtained by subtracting the measured voltage value from the predicted voltage value is less than the threshold value. Here, the threshold value may be set as a single value or as a range (e.g., a predetermined range) having an upper limit value and a lower limit value.

The control device 123 may be implemented by a battery management system (BMS) of the battery pack 10. However, the present disclosure is not limited thereto, and at least some constituent elements (for example, functions of the control device 123) of the charging control device 12 may be included in the charging device 20.

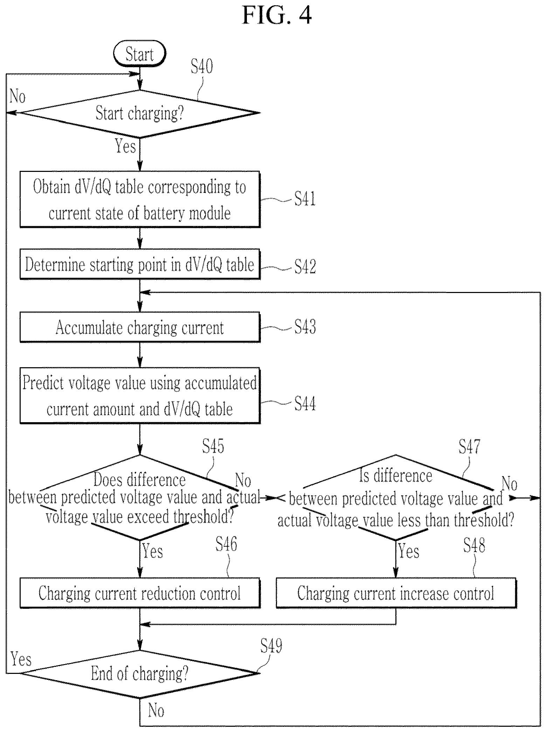

FIG. 4 schematically illustrates a charging control method of a charging control device according to one or more embodiments. The charging control method of FIG. 4 may be performed by the charging control device 12 described with reference to FIG. 1 to FIG. 3.

Referring to FIG. 4, if the battery pack 10 is connected to the charging device 20 such that charging is started (S40), the charging control device 12 may obtain a dV/dQ table corresponding to the current state of the battery module 11 (S41).

In operation S41, the charging control device 12 may determine the SOH and the temperature at the charging start time point of the battery module 11 based on the state values detected from the battery module 11 by the state detection device 121. Based on the determination, the charging control device 12 may obtain a dV/dQ table corresponding to the current state of the battery module 11 from the dV/dQ tables stored in the storage device 122.

In operation S41, if the battery module 11 includes a plurality of cells, the charging control device 12 may select a representative cell (for example, a weak cell) from cells configuring the battery module 11. In one or more embodiments, the charging control device 12 may obtain a dV/dQ table corresponding to the current state of the battery module 11 from the dV/dQ tables stored in the storage device 122 based on the SOH and the temperature detected at the charging start time point for the selected representative cell.

In operation S41, if the battery module 11 includes a plurality of cells, the charging control device 12 may obtain an average value of the SOH and the temperature detected from the cells configuring the battery module 11 at the charging start time point. In one or more embodiments, the charging control device 12 may also obtain a dV/dQ table corresponding to the current state of the battery module 11 from the dV/dQ tables stored in the storage device 122 based on the average SOH and the average temperature of the cells thus obtained.

In operation S41, if the dV/dQ table corresponding to the current SOH and the temperature of the battery module 11 is stored in the storage device 122, the charging control device 12 may read the dV/dQ table from the storage device 122 and use the dV/dQ table as the dV/dQ table of the battery module 11.

In operation S41, if the dV/dQ table corresponding to the current SOH and the temperature of the battery module 11 is not stored in the storage device 122, the charging control device 12 may read a dV/dQ table mapped to the SOH and the temperature close to the current SOH and the temperature of the battery module 11 among the dV/dQ tables stored in the storage device 122, and may determine the dV/dQ table as the dV/dQ table corresponding to the current state of the battery module 11.

In operation S41, if the dV/dQ table corresponding to the current SOH and the temperature of the battery module 11 is not stored in the storage device 122, the charging control device 12 may generate a dV/dQ table corresponding to the current state of the battery module 11 from the dV/dQ table stored in the storage device 122 using an interpolation method or the like.

If the dV/dQ table corresponding to the current state of the battery module 11 is obtained, the charging control device 12 may determine a starting point in the corresponding dV/dQ table (S42). The starting point in the dV/dQ table may be determined by the charging start SOC of the battery module 11.

The charging control device 12 may continuously accumulate the charging current detected by the state detection device 121 while the battery module 11 is being charged (S43).

In operation S43, the charging control device 12 may reduce or prevent the likelihood of the DCIR affecting the result by excluding the current component due to DCIR from the accumulated current amount when the charging current is accumulated.

In one or more embodiments, the charging control device 12 may predict the current voltage value of the battery module 11 using the accumulated current amount and the dV/dQ table corresponding to the current state of the battery module 11 (S44).

In operation S44, the charging control device 12 may calculate the amount of change in voltage of the cells configuring the battery module 11 based on the dV/dQ table corresponding to the current state of the battery module 11, and the charging control device 12 may add the amount of change in the voltage to the charging start voltage of the battery module 11 to predict the current voltage value of the cells configuring the battery module 11. The charging control device 12 may determine the accumulation section in the dV/dQ table of the battery module 11 using the start point determined through operation S42 and the end point determined by the current SOC of the cells configuring the battery module 11, and may calculate the amount of voltage change of the cell from the charging start time point to the current time point using the dV/dQ values of the accumulation section (see Equation 1 above).

If the voltage value of the cell configuring the battery module 11 is predicted, the charging control device 12 may compare a voltage difference between the predicted voltage value and the actual voltage value measured by the state detection device 121 with a threshold value. If the voltage difference between the predicted voltage value and the actual voltage value exceeds the threshold value (S45), the charging control device 12 may determine that the battery module 11 is being charged in the charging deterioration area of the cell and may control the charging device 20 to reduce the charging current (S46).

In one or more embodiments, if the voltage difference between the predicted voltage value and the actual voltage value is less than the threshold value (S47), the charging control device 12 may control the charging device 20 so that the charging device 20 increases the charging current to increase the charging speed of the battery module 11 (S48).

The charging control device 12 may repeatedly perform the aforementioned steps S43 to S48 until charging of the battery module 11 is completed (S49).

As described above, the charging control device 12 according to the present disclosure may continuously control the charging current so that the voltage difference between the voltage value predicted using the dV/dQ table and the actual voltage value measured by the state detection device 121 converges to the threshold value. In one or more embodiments, the charging control device 12 controls the charging current so that the battery module 11 may be charged near the boundary with the deterioration area of the cell, thereby reducing the charging time and reducing or minimizing deterioration of the battery module 11.

Electronic or electrical devices according to the embodiments and/or other related devices or constituent elements may be realized by using appropriate hardware, firmware (e.g., an application-specific integrated circuit), software, or combinations of software, firmware, and hardware. For example, various configurations of the above-noted devices may be positioned on one integrated circuit (IC) chip or an individual IC chip. In one or more embodiments, various configurations of the above-noted devices may be realized on a flexible printed circuit film, a tape carrier package (TCP), a printed circuit board (PCB), or one substrate. The electrical or mutual connections described in the present specification may, for example, be realized by the PCB, wires on different types of circuit carriers, or conductive elements. The conductive elements may, for example, include metallization, such as surface metallization and/or pins, and may include conductive polymers or ceramics. Further, electrical energy may be transmitted by electromagnetic radiation or a light-using radio access.

In one or more embodiments, the various configurations of the devices may be performed by one or more processors so as to perform the above-described various functions, they may be performed in one or more computing devices, and they may be processes or threads for performing computer program instructions and interacting with other system constituent elements. The computer program instruction is stored in a memory realizable in a computing device using a standard memory device, such as a random access memory (RAM). The computer program instruction may also be stored in a non-transitory computer readable medium, such as a CD-ROM or a flash drive.

Further, a person of ordinary skill in the art must understand that various functions of the computing device may be combined or united to a single computing device, or functions of a corresponding computing device may be dispersed to one or more other computing devices while not digressing from the range of the embodiments of the present invention.

While the present disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims, with functional equivalents thereof to be included therein.

### Description of Some Reference Characters

| | | | | | |
|---|---|---|---|---|---|
| 10: | battery pack | 11: | battery module | | |
| 12: | charging control unit | 121: | state detection device | | |
| 122: | storage device | 123: | control device | 20: | charging device |

### Claims

1. A charging control device comprising:

   a storage device configured to store tables defining a correlation between a change in capacity and a change in voltage of a cell and corresponding to different lifespan states and temperatures of the cell; and
   a control device configured to:

      obtain a table corresponding to a current state of a battery module from the tables based on a lifespan state and a temperature of the battery module at a charging start time point;
      obtain a predicted voltage value for the battery module using the obtained table and an accumulated current amount obtained by accumulating charging currents detected while charging is in progress; and
      control a charging current according to a comparison result of comparing a measured voltage value that is measured in the battery module with the predicted voltage value.

2. The charging control device as claimed in claim 1, wherein the tables comprise a differential value (dV/dQ) of a voltage with respect to a capacity of the cell, or comprise a value derived from the differential value (dV/dQ).

3. The charging control device as claimed in claim 2, wherein the control device is configured to:

   calculate a voltage change amount from the charging start time point to a current time point using the obtained table; and
   obtain the predicted voltage value by adding the voltage change amount to a charging start voltage value of the battery module detected at the charging start time point.

4. The charging control device as claimed in claim 3, wherein the control device is configured to:

   determine a state of charge (SOC) of the battery module at the current time point based on the accumulated current amount;
   extract the differential value (dV/dQ) from the obtained table based on a charging start state of charge (SOC) at the charging start time point of the battery module and the state of charge (SOC) at the current time point; and
   calculate the voltage change amount using the differential value (dV/dQ) extracted from the obtained table corresponding to the current state of the battery module.

5. The charging control device as claimed in any preceding claim, wherein the control device is configured to at least one of:

   decrease the charging current if a difference between the predicted voltage value and the measured voltage value exceeds a threshold value; and/or
   increase the charging current if the difference between the predicted voltage value and the measured voltage value is less than the threshold value,
   wherein optionally the threshold value comprises a single value, or comprises a range having an upper limit value and a lower limit value.

6. The charging control device as claimed in any preceding claim, wherein the control device is configured to exclude a current component due to direct current internal resistance (DCIR) from the accumulated current amount.

7. The charging control device as claimed in any preceding claim, wherein the control device is configured to communicate with a charging device, and to control the charging current applied from the charging device to the battery module through communication.

8. A battery pack comprising:

   the battery module comprising cells, and
   the charging control device as claimed in any preceding claim.

9. The battery pack as claimed in claim 8, wherein the control device is configured to obtain the table corresponding to the current state of the battery module based on a lifespan state and a temperature detected at the charging start time point for a representative cell selected from among the cells,
   wherein optionally the representative cell has a largest deterioration state among the cells.

10. The battery pack as claimed in claim 8, wherein the control device is configured to obtain the table corresponding to the current state of the battery module based on average values of lifespan states and temperatures detected at the charging start time point for the cells.

11. A charging control method of a battery pack, the method comprising:

    selecting, based on a lifespan state and a temperature at a charging start time point of a battery module, a table corresponding to a current state of the battery module from among tables that define a correlation between a change in capacity and a change in voltage of a cell, and that correspond to different lifespan states and temperatures of the cell;
    obtaining an accumulated current amount by accumulating a charging current detected during charging;
    obtaining a predicted voltage value for the battery module using the accumulated current amount and the selected table; and

controlling the charging current based on a measured voltage value that is measured in the battery module and the predicted voltage value.

**12.** The charging control method as claimed in claim 11, wherein the tables comprise a differential value (dV/dQ) of a voltage with respect to a capacity of the cell, or comprises a value derived from the differential value (dV/dQ).

**13.** The charging control method as claimed in claim 12, wherein obtaining the predicted voltage value comprises:

calculating a voltage change amount from the charging start time point to a current time point using the selected table and the accumulated current amount; and
adding the voltage change amount to a charging start voltage value of the battery module detected at the charging start time point,
wherein calculating the voltage change amount optionally comprises:

determining a state of charge (SOC) of the battery module at the current time point based on the accumulated current amount;
extracting the differential value (dV/dQ) from the selected table based on a charging start state of charge (SOC) at the charging start time point of the battery module and the state of charge (SOC) at the current time point; and
calculating the voltage change amount using the differential value (dV/dQ) extracted from the selected table corresponding to the current state of the battery module.

**14.** The charging control method as claimed in any of claims 11 to 13, wherein:

controlling the charging current comprises:

decreasing the charging current if a difference between the predicted voltage value and the measured voltage value exceeds a threshold value; and/or
increasing the charging current if the difference between the predicted voltage value and the measured voltage value is less than the threshold value,

the threshold value comprises a single value, or comprises a range having an upper limit value and a lower limit value.

**15.** The charging control method as claimed in any of claims 11 to 14, wherein obtaining the accumulated current amount comprises accumulating the charging current amount and excluding a current component due to direct current internal resistance from the accumulated current amount.

# FIG. 1

# FIG. 2

FIG. 3

# FIG. 4

```
                    ┌─────────┐
                    │  Start  │      S40
                    └────┬────┘
    No                   │
  ◄──────────────◄◇──────────────────────◇
              │   Start charging?        │
              ◇──────────────────────────◇
                    Yes │
                        ▼
        ┌──────────────────────────────────┐
        │ Obtain dV/dQ table corresponding │   S41
        │   to current state of battery    │
        │            module                │
        └────────────────┬─────────────────┘
                         ▼
        ┌──────────────────────────────────┐
        │  Determine starting point in     │  S42
        │          dV/dQ table             │
        └────────────────┬─────────────────┘
                         ▼
        ┌──────────────────────────────────┐
        │   Accumulate charging current    │  S43
        └────────────────┬─────────────────┘
                         ▼
        ┌──────────────────────────────────┐
        │ Predict voltage value using      │  S44
        │ accumulated current amount and   │
        │          dV/dQ table             │
        └────────────────┬─────────────────┘
                         │           S45                          S47
                         ▼
           ◇─────────────────────────◇  No    ◇──────────────────────────────◇  No
           │ Does difference between  │───────►│ Is difference between         │────►
           │ predicted voltage value  │        │ predicted voltage value and   │
           │ and actual voltage value │        │ actual voltage value less     │
           │    exceed threshold?     │        │      than threshold?          │
           ◇─────────────────────────◇        ◇──────────────────────────────◇
                     Yes │     S46                       Yes │      S48
                         ▼                                   ▼
        ┌──────────────────────────────┐    ┌──────────────────────────────────┐
        │ Charging current reduction   │    │  Charging current increase        │
        │          control             │    │          control                  │
        └──────────────┬───────────────┘    └────────────────┬─────────────────┘
                       │                                      │
                       ▼◄─────────────────────────────────────
    Yes                │                        S49
  ◄──────────────◇─────────────────────────◇
              │      End of charging?        │
              ◇──────────────────────────────◇
                       No │
```

Europäisches
Patentamt

European
Patent Office

Office européen
des brevets

# EUROPEAN SEARCH REPORT

**Application Number**

EP 24 15 0263

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 506 452 A1 (SAMSUNG ELECTRONICS CO LTD [KR]) 3 July 2019 (2019-07-03) <br> * figures 7,8,9 * <br> * paragraph [0060] * <br> * paragraph [0071] - paragraph [0077] * <br> * paragraph [0097] - paragraph [0103] * <br> ----- | 1-15 | INV. <br> H02J7/00 |
| A | WO 2022/168151 A1 (MITSUBISHI ELECTRIC CORP [JP]) 11 August 2022 (2022-08-11) <br> * figure 4 * <br> * paragraph [0025] * <br> ----- | 1,11 | |
| A | CN 104 051 799 B (GM GLOBAL TECH OPERATIONS INC) 12 September 2017 (2017-09-12) <br> * figure 3 * <br> * paragraph [0060] - paragraph [0063] * <br> ----- | 1,11 | |
| A | US 2022/163594 A1 (KUOVO MIKKO [SE] ET AL) 26 May 2022 (2022-05-26) <br> * figures 3, 4 * <br> * paragraph [0029] * <br> * paragraph [0057] - paragraph [0059] * <br> ----- | 7 | TECHNICAL FIELDS SEARCHED (IPC) <br><br> H02J <br> G01R |

The present search report has been drawn up for all claims

| Place of search | Date of completion of the search | Examiner |
|---|---|---|
| Munich | 24 June 2024 | Despis, Enguerran |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...............................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 15 0263

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2024

| Patent document cited in search report | | Publication date | Patent family member(s) | | Publication date |
|---|---|---|---|---|---|
| EP 3506452 | A1 | 03-07-2019 | CN | 109994792 A | 09-07-2019 |
| | | | EP | 3506452 A1 | 03-07-2019 |
| | | | KR | 20190081237 A | 09-07-2019 |
| | | | US | 2019202299 A1 | 04-07-2019 |
| | | | US | 2021053450 A1 | 25-02-2021 |
| WO 2022168151 | A1 | 11-08-2022 | DE | 112021006998 T5 | 30-11-2023 |
| | | | JP | 7466713 B2 | 12-04-2024 |
| | | | JP | WO2022168151 A1 | 11-08-2022 |
| | | | US | 2024044994 A1 | 08-02-2024 |
| | | | WO | 2022168151 A1 | 11-08-2022 |
| CN 104051799 | B | 12-09-2017 | CN | 104051799 A | 17-09-2014 |
| | | | US | 2014266060 A1 | 18-09-2014 |
| US 2022163594 | A1 | 26-05-2022 | AU | 2020215238 A1 | 05-08-2021 |
| | | | CA | 3125939 A1 | 06-08-2020 |
| | | | EP | 3686618 A1 | 29-07-2020 |
| | | | FI | 3686618 T3 | 25-04-2023 |
| | | | PL | 3686618 T3 | 29-05-2023 |
| | | | US | 2022163594 A1 | 26-05-2022 |
| | | | WO | 2020157038 A1 | 06-08-2020 |

EPO FORM P0459

For more details about this annex : see Official Journal of the European Patent Office, No. 12/82